# EUROPEAN PATENT APPLICATION

(11) **EP 1 389 780 A2**
(43) Date of publication of application: **18.02.2004**
(21) Application number: 03017638.2
(22) Date of filing: 12.08.2003
(51) Int. Cl.: G11C 11/16

(54) **Semiconductor integrated circuit device**

(30) Priority: 12.08.2002 JP 2002235070
(71) Applicant: Kabushiki Kaisha Toshiba, Tokyo (JP)
(72) Inventor: Asao, Yoshiaki, Intell. Prop. Div., Toshiba Corp., Tokyo 105-8001 (JP)
(74) Representative: HOFFMANN - EITLE

(57) **Abstract**

A semiconductor integrated circuit device comprises a first column gate circuit (CG0) that electrically connects a first bit line group (2-0) to a data line group (1) according to a first column selection signal (CSL0), a second column gate circuit (CG1) that electrically connects a second bit line group (2-1) to the data line group (1) according to a second column selection signal (CSL1), word lines (WWL) that intersect the bit lines (BL) and memory cells (10) that are electrically connected to the bit lines (BL) are selected by the word lines (WWL) and include magneto-resistive elements (12). The spinning directions of the magneto-resistive elements (12) are perpendicular to the bit lines (BL) as seen in a plan view.

## Description

This invention relates to a semiconductor integrated circuit device comprising a memory cell including magneto-resistive elements.

A variety of memories adapted to store information on the basis of novel theorems have been proposed in recent years. As such memories, magnetic random memories that utilize the magneto-resistive effect, the tunneling magneto-resistive (to be referred to as TMR hereinafter) effect proposed by Roy Scheuerlein et al. in particular, are known.

### (Reference Paper)

### ISSCC2000 Technical Digest p. 128 "A 10ns Read and Write Non-Volatile Memory Array Using a Magnetic Tunnel Junction and FET Switch in each Cell"

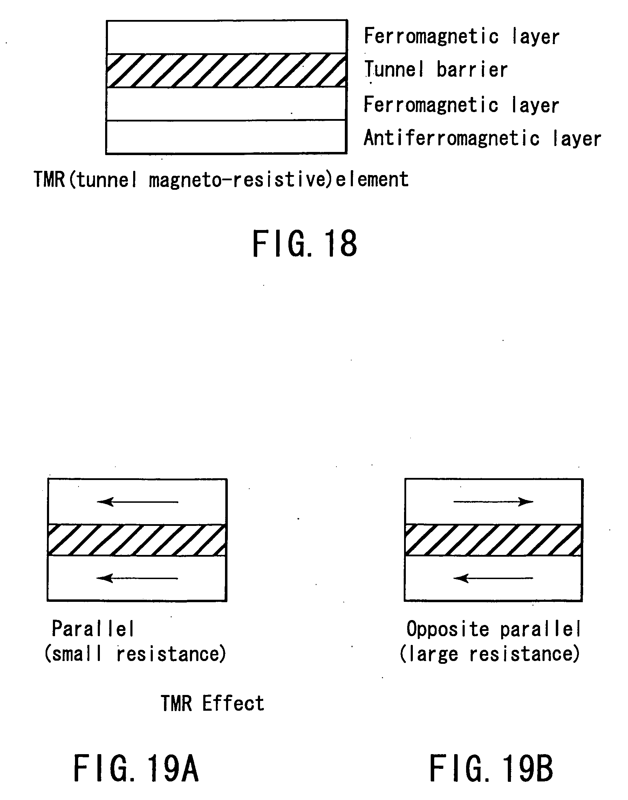

A magnetic random access memory stores information in the form of "1s" and "0s" by means of TMR elements. As shown in FIG. 18 of the accompanying drawing, the TMR element has a structure of sandwiching an insulating layer (tunnel barrier layer) between a pair of magnetic layers (ferromagnetic layers). The information stored in a TMR element is judged on the basis if the spinning directions of the paired magnetic layers are in parallel or in opposite parallel.

Referring to FIGS. 19A and 19B, "parallel" refers to a situation where the spinning directions of the paired magnetic layers are identical, whereas "opposite parallel" refers to a situation where the spinning directions of the paired magnetic layers are opposite relative to each other (arrows indicate show spinning directions).

Normally, an antiferromagnetic layer is arranged at the side of one of the paired magnetic layers. The antiferromagnetic layer is a member that is adapted to facilitate the operation of writing information by fixing the spinning direction of the one magnetic layer and reversing the spinning direction of the other magnetic layer.

The tunnel resistance of the insulating layer (tunnel barrier layer) sandwiched by between the paired magnetic layers is minimized when the spinning directions of the two magnetic layers are in parallel as shown in FIG. 19A. This state may be "1" state.

On the other hand, the tunnel resistance of the insulating layer (tunnel barrier layer) is maximized when the spinning directions of the two magnetic layers are in opposite parallel as shown in FIG. 19B. This state may be "0" state.

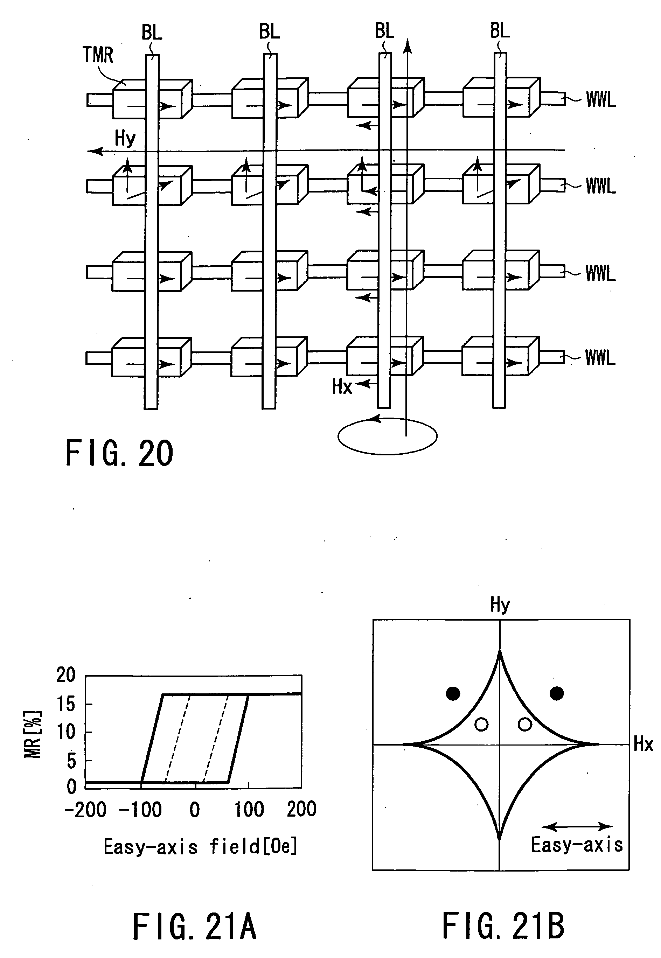

Now, the principle underlying the operation of writing information on the TMR element will be briefly described with reference to FIG. 20.

The TMR element is arranged on the crossing of a write word line WWL and a data selection line (bit line) BL that intersect each other. The writing operation is performed by causing electric currents to flow respectively through the write word line WWL and the data selection line BL and making the spinning directions of the TMR element in parallel or in opposite parallel relative to each other by means of the magnetic field produced by the electric currents flowing through the wires.

When writing a data, an electric current is made to flow through the data selection line BL only in a given direction, whereas the electric current that flows through the write word line WWL is made to run in a direction or in the opposite direction depending on the data to be written. The spinning directions of the TMR element are in parallel (in the "1" state) when an electric current is made to flow through the write word line WWL in the first direction, whereas the spinning directions of the TMR element are in opposite parallel (in the "0" state) when an electric current is made to flow through the write word line WWL in the second direction.

The spinning directions of the TMR element are changed in a manner as described below.

Referring to FIG. 21A showing a TMR curve, the resistance of the TMR element changes typically by 17% when a magnetic field Hx is applied to it along a long side (easy-axis) of the TMR element. The rate of the change, or the ratio of the resistances observed before and after the change is referred to as MR ratio.

The MR ratio can vary depending on the nature of the magnetic layers. Currently, TMR elements showing an MR ratio of about 50% are available.

The combined magnetic field of the magnetic field Hx in the direction of the easy-axis and the magnetic field Hy in the direction of the hard-axis is applied to the TMR element. As shown by the solid lines and the dotted lines in FIG. 21A, the magnitude of the magnetic field Hx in the direction of the easy-axis that is necessary for changing the resistance of the TMR element can change depending on the magnitude of the magnetic field Hy in the direction of the hard-axis. It is possible to write a data only on the TMR element arranged on the crossing of the selected write word line WWL and the selected data selection line BL out of the memory cells arranged in the form of an array by utilizing this phenomenon.

This will be described further with reference to the asteroidal curve illustrated in FIG. 21B.

FIG. 21B shows a typical asteroidal curve of a TMR element by means of solid lines. If the magnitude of the combined magnetic field of the magnetic field Hx in the direction of the easy-axis and the magnetic field Hy in the direction of the hard-axis is found outside the asteroidal curve (solid lines) (as indicated by black dots), it is possible to reverse the spinning direction of the related magnetic layer.

Conversely, if the magnitude of the combined magnetic field of the magnetic field Hx in the direction of the easy-axis and the magnetic field Hy in the direction of the hard-axis is found inside the asteroidal curve (solid lines) (as indicated by white dots), it is not possible to reverse the spinning direction of the related magnetic layer.

Therefore, it is possible to control the operation of writing data on the TMR element by changing the magnitude of the combined magnetic field of the magnetic field Hx in the direction of the easy-axis and the magnetic field Hy in the direction of the hard-axis as indicated by a position in the Hx-Hy plane.

The data written on a selected TMR element can be read out by flowing an electric current to the TMR element and detecting the resistance of the TMR element.

Efforts are being made to realize a multi-bit operation in such a magnetic random access memory.

The present invention has been made in view of the above described circumstances. An object of the invention is to provide a semiconductor integrated circuit device comprising memory cells that include magneto-resistive elements and adapted to write data to a multiple of bits at the same time.

A semiconductor integrated circuit device according to a first aspect of the present invention comprises: a data line group including a plurality of data lines; a first bit line group including a plurality of bit lines; a first column gate circuit that electrically connects the first bit line group to the data line group according to a first column selection signal; a second bit line group including a plurality of bit lines; a second column gate circuit that electrically connects the second bit line group to the data line group according to a second column selection signal different from the first column selection signal; a plurality of word lines intersecting the plurality of bit lines included in the first and second bit line groups; and a plurality of memory cells including magneto-resistive elements and adapted to be electrically connected to a plurality of bit lines included in the first and second bit line groups and selected by the plurality of word lines; wherein spinning directions of the magneto-resistive elements are perpendicular to the plurality of bit lines included in the first and second bit line groups as seen on a plan view.

A semiconductor integrated circuit device according to a second aspect of the present invention comprises: a data line group including a plurality of data lines; a first bit line group including a plurality of bit lines; a first column gate circuit that electrically connects the first bit line group to the data line group according to a first column selection signal; a second bit line group including a plurality of bit lines; a second column gate circuit that electrically connects the second bit line group to the data line group according to a second column selection signal different from the first column selection signal; a plurality of word lines intersecting the plurality of bit lines included in the first and second bit line groups; and a plurality of memory cells including magneto-resistive elements and adapted to be electrically connected to a plurality of bit lines included in the first and second bit line groups and selected by the plurality of word lines; wherein the magneto-resistive elements are rectangular with short sides and long sides as seen on a plan view and the long sides intersect the plurality of bit lines included in the first and second bit line groups as seen in a plan view.

A semiconductor integrated circuit device according to a third aspect of the present invention comprises: a data line group including a plurality of data lines; a first bit line group including a plurality of bit lines; a first column gate circuit that electrically connects the first bit line group to the data line group according to a first column selection signal; a second bit line group including a plurality of bit lines; a second column gate circuit that electrically connects the second bit line group to the data line group according to a second column selection signal different from the first column selection signal; a plurality of word lines intersecting the plurality of bit lines included in the first and second bit line groups; and a plurality of memory cells including magneto-resistive elements and adapted to be electrically connected to a plurality of bit lines included in the first and second bit line groups and selected by the plurality of word lines; wherein the magneto-resistive elements are parallelogramic with short sides and long sides as seen on a plan view and the long sides intersect the plurality of bit lines included in the first and second bit line groups as seen in a plan view.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a block diagram showing a magnetic random access memory according to a first embodiment of this invention,
FIG. 2 is an equivalent circuit diagram showing the magnetic random access memory according to the first embodiment of this invention,
FIG. 3 is a schematic plan view showing the magnetic random access memory according to the first embodiment of this invention,
FIGS. 4A and 4B are schematic cross sectional views showing the magnetic random access memory according to the first embodiment of this invention, showing the spinning directions thereof,
FIG. 5A is a schematic plan view showing a first example of a memory cell,
FIG. 5B is a schematic cross sectional view taken along line 5B-5B in FIG. 5A,
FIG. 5C is a schematic cross sectional view taken along line 5C-5C in FIG. 5A,
FIG. 5D is an equivalent circuit diagram of the memory cell of FIG. 5A,
FIG. 6 is a schematic plan view showing a magnetic random access memory according to a second embodiment of this invention,
FIG. 7 is a schematic plan view showing a magnetic random access memory according to a third embodiment of this invention,
FIG. 8 is a schematic cross sectional view showing another example of a memory cell,
FIG. 9 is a schematic cross sectional view showing still another example of a memory cell,
FIG. 10A is a schematic cross sectional view showing a magneto-resistive effect element according to a first example,
FIG. 10B is a schematic cross sectional view showing a magneto-resistive effect element according to a second example,
FIG. 10C is a schematic cross sectional view showing a magneto-resistive effect element according to a third example,
FIG. 10D is a schematic cross sectional view showing a magneto-resistive effect element according to a fourth example,
FIG. 11 is a block diagram showing a DSL data path portion of a modem for a digital subscriber line (DSL), for illustrating an application example 1 of the MRAM according to any one of the first to third embodiments of this invention,
FIG. 12 is a block diagram showing a portable telephone terminal, for illustrating an application example 2 of the MRAM according to any one of the first to eleventh embodiments of this invention,
FIG. 13 is a top plan view showing an example in which the MRAM is applied to a card (MRAM card) which receives media contents such as smart media, for illustrating an application example 3 of the MRAM according to any one of the first to eleventh embodiments of this invention,
FIG. 14 is a plan view showing a transfer device used to transfer data to an MRAM card,
FIG. 15 is a cross-sectional view showing a transfer device used to transfer data to an MRAM card,
FIG. 16 is a cross-sectional view showing a fitting type transfer device used to transfer data to an MRAM card,
FIG. 17 is a cross-sectional view showing a slide type transfer device used to transfer data to an MRAM card,
FIG. 18 is a schematic cross sectional view showing a TMR element,
FIGS. 19A and 19B are diagrams showing a TMR effect,
FIG. 20 is a diagram showing a principle underlying the operation of writing data,
FIG. 21A is a diagram showing a TMR curve, and
FIG. 21B is a diagram showing an asteroidal curve.

The present invention will be described with reference to the accompanying drawings. The components identical or similar to one another are denoted at the same reference symbols in the drawings.

### (1st Embodiment)

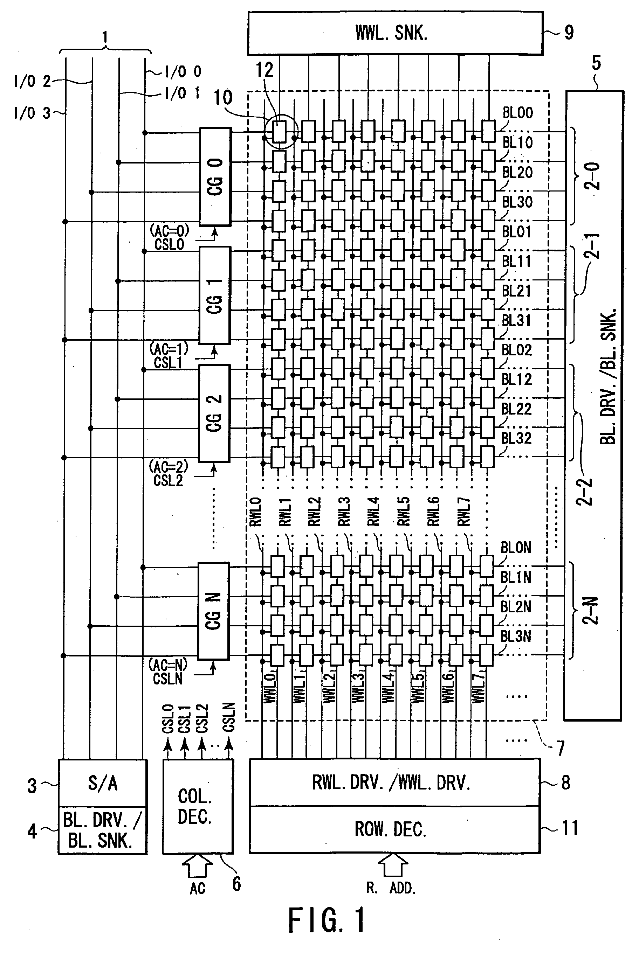

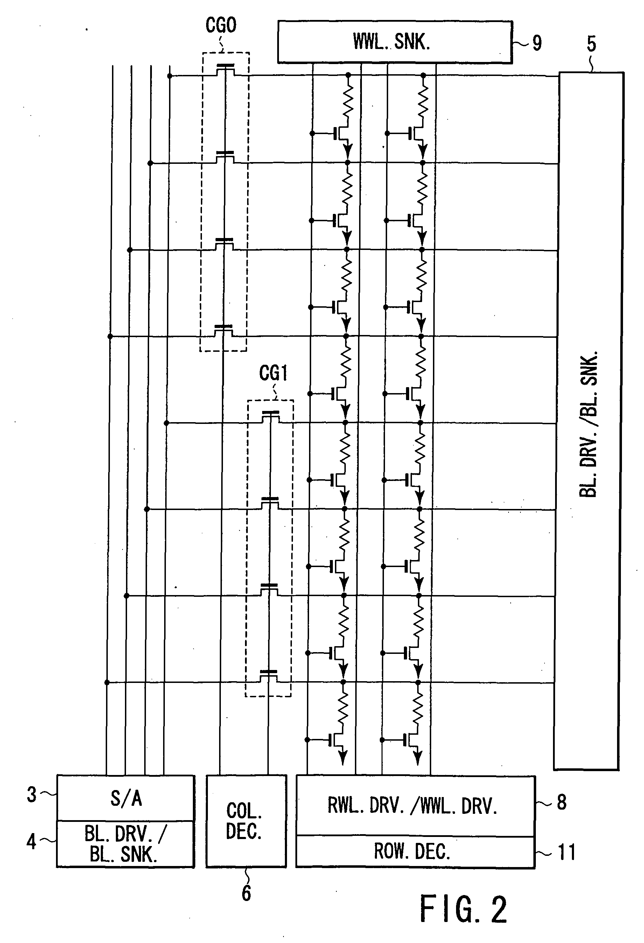

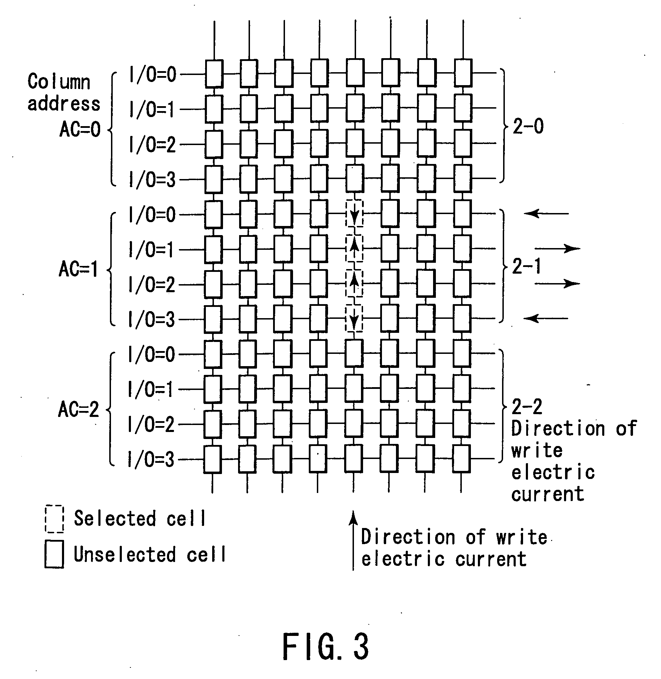

FIG. 1 is a block diagram showing a magnetic random access memory according to a first embodiment of this invention, FIG. 2 is an equivalent circuit diagram showing the magnetic random access memory according to the first embodiment of this invention, FIG. 3 is a schematic plan view showing the magnetic random access memory according to the first embodiment of this invention.

As shown in FIGS. 1 through 3, the magnetic random access memory according to the first embodiment comprises a data line group 1, first through N-th bit line groups 2-0, ..., 2-N, first through N-th column gate circuits CG0, ..., CGN, a plurality of read word lines RWL0 ..., RWL7, ..., a plurality of write word lines WWL0 ..., WWL7, ... and a plurality of memory cells including magneto-resistive elements.

The data line group 1 includes a plurality of data lines. In this embodiment, it includes four data lines I/00, ..., I/03. The data lines I/00, ..., I/03 are electrically connected to a sense amp circuit (S/A) 3 and a bit line driver circuit/bit line sinker circuit (BL. DRV. /BL . SNK.) 4. The sense amp circuit 3 determines the logical values of the read data transmitted to the data lines I/00, ..., I/03 typically with reference to a reference voltage and amplifies the potentials corresponding to the logical values of the data in a data reading operation. The bit line driver circuit/bit line sinker circuit 4 is a circuit that controls the directions of the write electric currents that are made to flow through the bit lines in a data writing operation.

Each of the first through N-th bit line groups 2-0, ..., 2-N includes a plurality of bit lines. In this embodiment, they include four bit lines BL00, ..., BL30, BL01, ..., BL31, BL02, ... BL32, ..., BL0N, ..., BL3N. The bit lines BL00 through BL3N of this embodiment are adapted to read/write operations. Each of the bit lines BL00 through BL3N is connected at an end thereof to the bit line driver circuit/bit line sinker circuit (BL. DRV./BL.SNK.) 5 and at the other end to corresponding one of the first through N-th column gate circuits CG0 ..., CGN. The first through N-th column gate circuits CG0, ..., CGN electrically connect one of the first through N-th bit line groups 2-0, ..., 2-N to the data line group 1 according to first through N-th column selection signals CSL0 ..., CSLN. The first through N-th column selection signals CSL0 ..., CSLN are typically output from a column decoder (COL. DEC.) 6. The column decoder 6 brings one of the first through N-th column selection signals CSL0, ..., CSLN up to level "HIGH", for example, typically according to the logical value of column address AC. As a result, one of the first through N-th column gate circuit CG0, ..., CGN is selected and the bit line group that is connected to the selected column gate circuit is electrically connected to the data line group 1. As the bit line group is electrically connected to the data line group 1, the first embodiment of magnetic random access memory of the first embodiment performs a multi-bit operation. A multi-bit operation is an operation of reading or writing data to a multiple of bits, for example, at a time. In this embodiment, an operation of reading or writing data of four bits is performed at a time. Bit line driver circuit/bit line sinker circuit 5 controls the direction of the electric currents that are made to through the bit lines in a data writing operation along with the bit line driver circuit/bit line sinker circuit 4.

The plurality of read word lines RWL0, ..., RWL7 and the plurality of write word lines WWL0 ..., WWL7 intersect the bit lines BL00, ..., BL3N typically in memory cell array 7. The read word lines RWL0, ..., RWL7 are connected at an end thereof to the read word line driver circuit of read word line driver circuit/write word line driver circuit (RWL. DRV./WWL. DRV.) 8. The read word lines WWL0, ..., WWL7 are connected at an end thereof to the write word line driver circuit of read word line driver circuit/write word line driver circuit 8 and at the other end to write word line sinker circuit (WWL. SNK.) 9.

A plurality of memory cells 10 that include magneto-resistive elements are arranged in the form of a matrix in the memory cell array 7. The magneto-resistive elements may be so-called TMR elements that utilize the tunneling magneto-resistive (TMR) effect. Each of the plurality of memory cells 10 is electrically connected to a bit line BL and adapted to be selected to operate by a read word line WWL.

Row decoder 11 selects a row of the memory cell array 7 in a data reading or data writing operation. The row decoder 11 brings one of the read word lines RWL or the write word lines WWL up to level "HIGH", for example, by way of the read word line driver circuit/write word line driver circuit 8 typically according to the logical value of row address R. ADD. As a result, a row of the memory cell array 7 is selected.

For instance, as shown in an equivalent circuit diagram of FIG. 2 each memory cell may be adapted to use a MOSFET as switching element. The MOSFET that operates as switching element may be replaced by a diode.

An operation example will be described below.

Now, assume that four bit lines are driven to operate simultaneously.

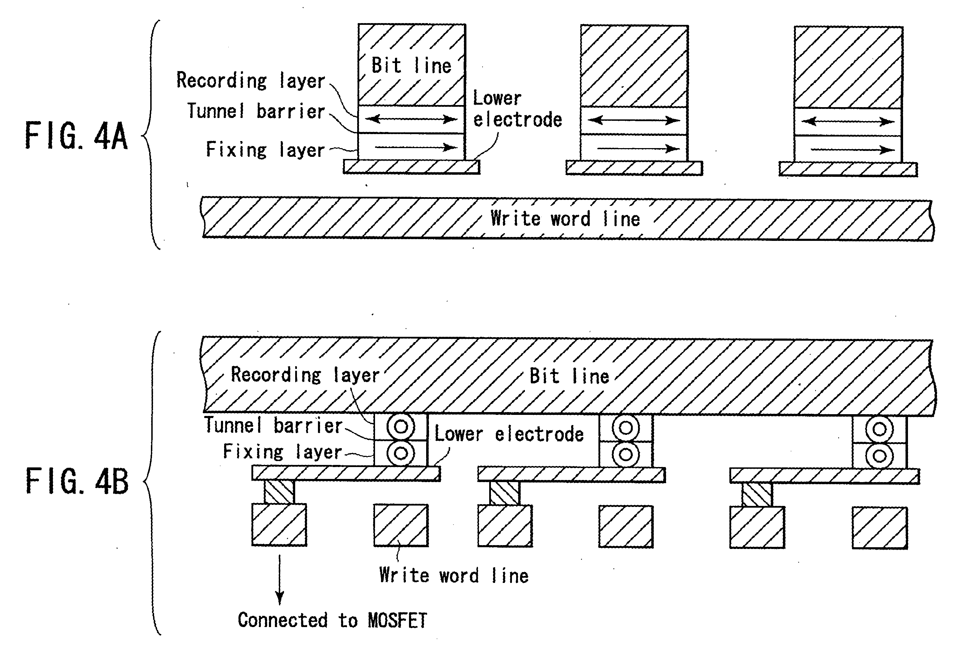

Also assume that column address AC = 1 is selected as shown in FIG. 3. Then, the bit line group 2-1 is selected and the four bit lines belonging to the group are driven to operate simultaneously. As one of the write word lines is selected, the four bits that are shown as selected cells in FIG. 3 are selected at a time. When writing desired data respectively to the four bits that are selected at a time, an electric current is made to flow through the selected write word line in a given direction. As a result, a magnetic field is applied to the four bits in the same direction. To write desired data respectively to the four bits, electric currents are made to flow respectively through the selected four bit lines in desired directions. As a result, the spinning directions of the magnetic recording layers of the TMR elements change. In this embodiment, the spinning directions of the TMR elements are perpendicular to the bit lines as seen in a plan view. The spinning directions of the TMR elements are shown in the cross sectional views of FIGS. 4A and 4B.

Referring to FIGS. 4A and 4B, as the spinning directions of the TMR elements are made perpendicular to the bit lines as seen in a plan view, it is possible to write data to a multiple of bits at the same time.

In a semiconductor process, metal wires arranged in an upper layer are made to have a greater width. Thus, as shown in FIGS. 4A and 4B, the width of the bit lines arranged on the TMR elements is greater than that of the word lines arranged below the TMR elements. When the TMR elements are rectangular, the spinning directions are in parallel with the long sides of the TMR elements. Therefore, it may be better to change the spinning direction of a TMR element by means of the direction of the electric current flowing through a wire arranged above the TMR element rather than to change it by means of a wire located below the TMR element.

Thus, in the first embodiment, the spinning directions of the TMR elements are made to be perpendicular to the bit lines as seen in a plan view. As a result, when writing data, it is possible to change the directions of the electric currents that correspond to "0" and "1" not by means of write word lines but by means of bit lines. Thus, it is possible to simultaneously write data in a multiple of bits having memory cells that include magneto-resistive elements.

Now, memory cells that can be used for a magnetic random access memory according to embodiments of this invention will be described below.

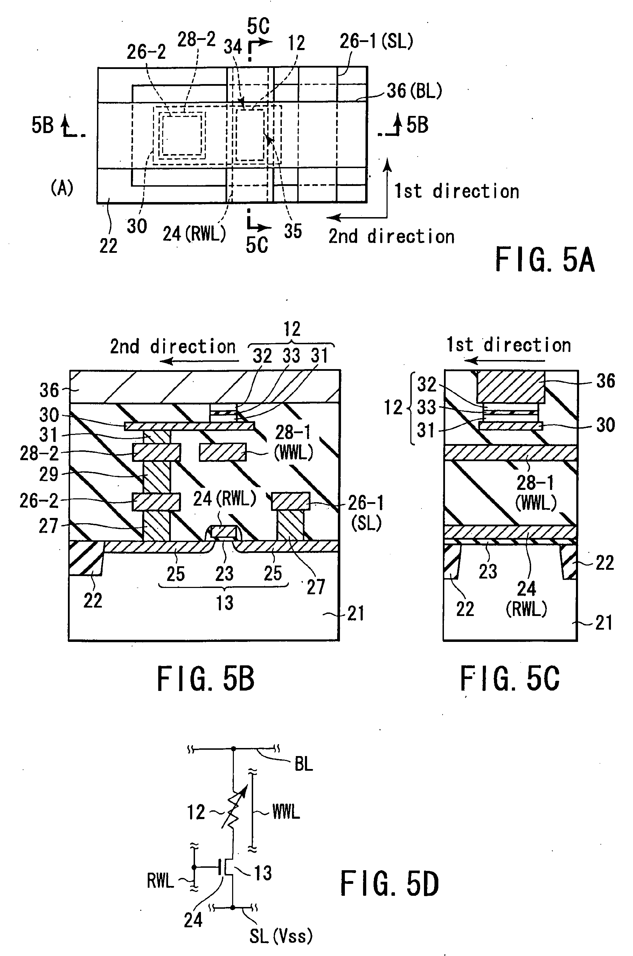

FIG. 5A is a schematic plan view showing a first example of a memory cell, FIG. 5B is a schematic cross sectional view taken along line 5B-5B in FIG. 5A, FIG. 5C is a schematic cross sectional view taken along line 5C-5C in FIG. 5A, FIG. 5D is an equivalent circuit diagram of the memory cell of FIG. 5A.

As shown in FIGS. 5A through 5D, this first example of memory cell that include a magneto-resistive element is a 1-magnetoresistive element/1-transistor type memory cell having a magneto-resistive element 12 and a cell transistor 13.

For instance, the cell transistor 13 is formed in an element region of a P-type silicon substrate 21, for example. The element region is defined by element separating regions 22 also formed on the substrate 21. The cell transistor 13 has a gate electrode 24 and an N-type source/drain region 25. The gate electrode 24 is insulated from the substrate 21 by a gate insulating film, which may typically be a gate oxide film 23, and extends in a first direction to operate as read word line RWL. A source line (SL) 26-1 and an intra-cell via 26-2 are formed above the cell transistor 13. They are typically formed by a first layer, which is a metal layer. The source line 26-1 extends in the first direction same as the extending direction of the read word line RWL and is connected to either of the source/drain region 25, the source region for example, of the cell transistor by way of first layer metal/substrate contact 27. On the other hand, the intra-cell via 26-2 is connected to the other of the source/drain region 25, the drain region for example, of the cell transistor by way of the first layer metal/substrate contact 27. A write word line (WWL) 28-1 and an intra-cell via 28-2 are formed above the source line 26-1 and the intra-cell via 26-2. They are typically formed by a second layer, which is a metal layer. The intra-cell via 28-2 is connected to the intra-cell via 26-2 typically by way of second layer metal/first layer metal contact 29. On the other hand, the write word line 28-1 extends in the first direction same as the extending direction of the read word line RWL. An intra-cell local wire 30 is formed above the write word line 28-1 and the intra-cell via 28-2. The intra-cell local wire is typically formed by a third layer, which is a metal layer. The intra-cell local wire 30 is connected to the intra-cell via 28-2 by way of third layer metal/second layer metal contact 31. A magneto-resistive element 12, which may typically be a TMR element, is formed on the intra-cell local wire 30. The TMR element includes a magnetization fixing layer 31 and a magnetic recording layer 32, which are typically ferromagnetic layers, along with a tunnel barrier layer 33, which is an insulating non-magnetic layer formed between the magnetization fixing layer 31 and the magnetic recording layer 32. The magnetization fixing layer 31 is a layer in which the spinning direction is fixed, whereas the magnetic recording layer 32 is a layer in which the spinning direction changes according to the write magnetic field applied to it. As shown in the plan view of FIG. 5A, the TMR element of this embodiment is rectangular and has short sides 34 and long sides 35 when seen in a plan view. The spinning direction of the magnetization fixing layer 31 is defined when it is annealed after the operation of processing the TMR element, while a magnetic field is being applied to it. If the TMR element has a rectangular contour, the spinning direction is defined to be in parallel with the long sides on a stable basis. Then, the magnetic field is applied in a direction parallel to the long sides. The TMR element is arranged in such a way that its long sides run in the first direction in which the write word line 28-1 extends. With this arrangement, the easy magnetization axis (easy-axis) of the TMR element runs in the first direction in which the write word line 28-1 extends. The magnetization fixing layer 31 is connected to the intra-cell local wire 30, while the magnetic recording layer 32 is connected to bit line (BL) 36. The bit line 36 is typically formed by a fourth layer, which is a metal layer. The bit line 36 is made to extend in a second direction that perpendicularly intersects the first direction. With this arrangement, the long sides of the TMR element intersect, typically perpendicularly, the bit line 36 when seen in a plan view as shown in the plan view of FIG. 5A.

### (2nd Embodiment)

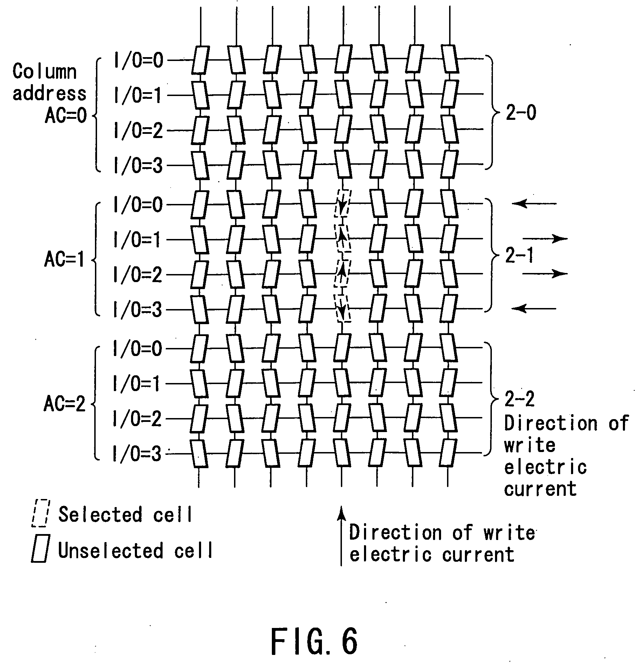

FIG. 6 is a schematic plan view showing a magnetic random access memory according to a second embodiment of this invention.

As shown in FIG. 6, in the second embodiment, the spinning directions of the TMR elements are not perpendicular to but inclined relative to the bit lines when seen in a plan view. With this arrangement, the TMR elements show the form of a parallelogram having short sides and long sides, which may be a rhombus. When the TMR elements are parallelogramic, the spinning directions of the TMR elements are made to run toward between the two corners that show an acute angle. As a result, the spinning directions of the TMR elements are not perpendicular to but inclined relative to the bit lines. It is possible to suppress the cross talk during a data writing operation by making the TMR elements have a parallelogramic contour and alternately arranging TMR elements that are inclined rightward and those that are inclined leftward as shown in FIG. 6.

### Reference Paper: United States Patent No. 6,005,800

In this embodiment, if the TMR elements are made to show the form of a parallelogram having short sides and long sides as seen in a plan view, they are arranged in such a way that their long sides intersect . the bit lines as seen in a plan view.

With this arrangement, when writing data, it is possible to change the directions of the electric currents that correspond to "0" and "1" not by means of write word lines but by means of bit lines as in the case of the first embodiment. Thus, as in the case of the first embodiment, it is possible to simultaneously write data in a multiple of bits.

### (3rd Embodiment)

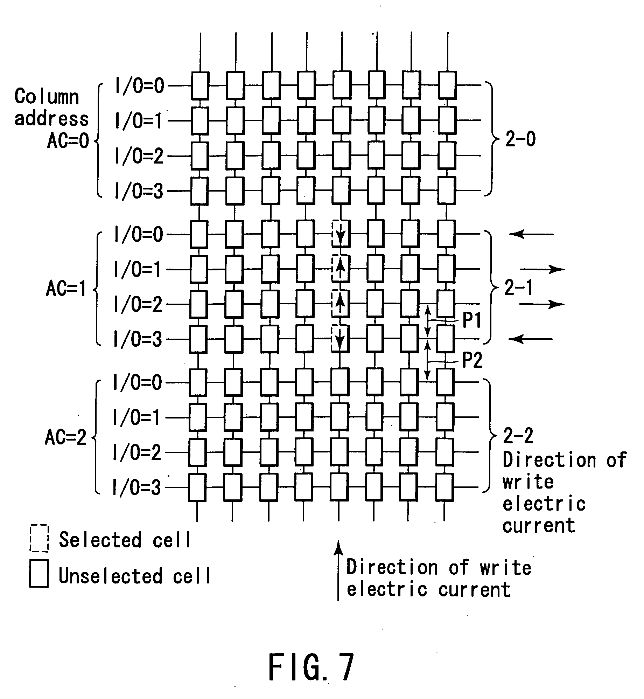

FIG. 7 is a schematic plan view showing a magnetic random access memory according to a third embodiment of this invention.

As shown in FIG. 7, in the third embodiment, the pitch P2 of arrangement of bit line groups is made greater than the pitch P1 of arrangement of bit lines in each of the bit line groups.

With this arrangement, the influence of magnetic field due to the write electric current flowing through the selected bit line group on unselected bit lines is suppressed. As a result, it is possible to suppress the cross talk during a data writing operation.

Additionally, a cross talk can hardly arise with the above arrangement because a write electric current flows through a plurality of bit lines of the selected bit line group in a data writing operation. Therefore, the pitch of arrangement of bit lines in each of the bit line groups can be made smaller than the pitch of arrangement of bit line groups. Then, it is possible to enhance the density of memory cell array.

The above described effect can be realized by making the pitch of arrangement of magneto-resistive elements greater than the pitch of arrangement of bit line groups.

This third embodiment can be combined with the second embodiment.

### [Examples of Memory Cells]

A 1-magnetoresistive element/1-transistor type memory cell having a magneto-resistive element and a cell transistor is described as an example of memory cell for the first embodiment.

However, a memory cell other than a 1-magnetoresistive element/1-transistor type memory cell may alternatively be used for the purpose of the present invention.

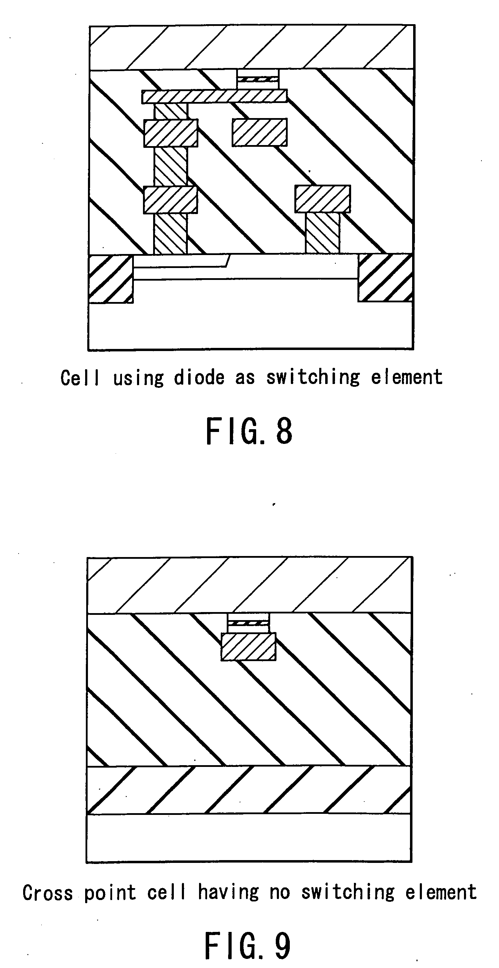

For example, a cell realized by using a diode in place of a transistor as switching element as shown in FIG. 8 or a cross point type cell having no switching element as shown in FIG. 9 may be used.

Advantages similar to those of the first through third embodiments are provided when such cells are used for the memory cells of the first through third embodiments of magnetic random access memory.

### [Examples of Magneto-resistive Effect Elements]

### [1st Example]

TMR elements can be used for the magneto-resistive effect elements 3 described above for the first through third embodiments. Now, several examples of TMR element will be described below.

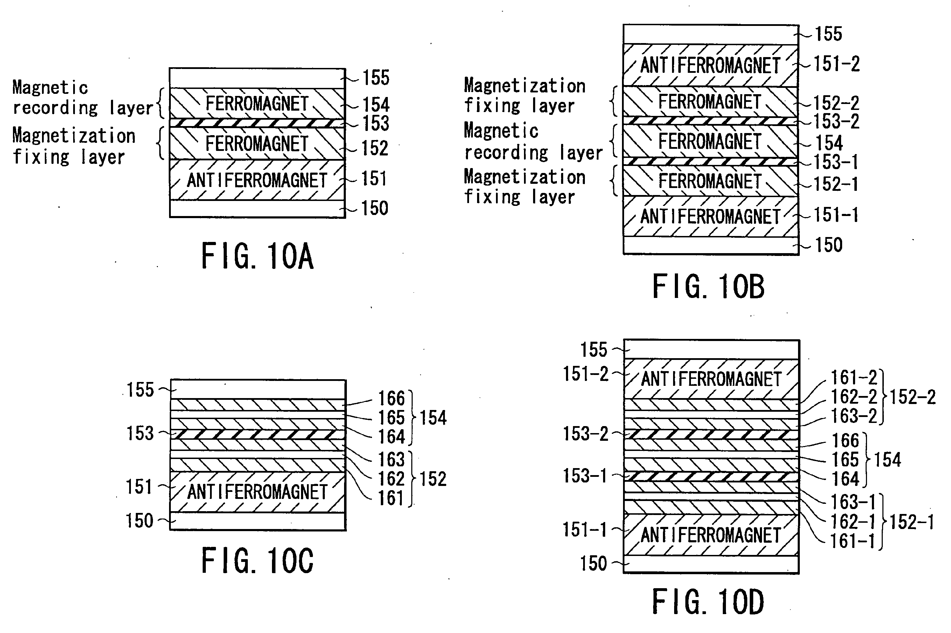

FIG. 10A is a schematic cross sectional view showing a magneto-resistive effect element according to a first example.

As shown in FIG. 10A, an antiferromagnetic layer 151, a ferromagnetic layer 152, a tunnel barrier layer 153, a ferromagnetic layer 154 and a protection layer 155 are sequentially formed on an underlayer 150.

In this example, the ferromagnetic layer 152 operates as magnetization fixing layer in which the spinning direction is fixed, whereas the ferromagnetic layer 154 operates as magnetic recording layer in which the spinning direction is changed. The antiferromagnetic layer 151 is a layer to be used for fixing the spinning direction of the ferromagnetic layer 152. The spinning direction of the ferromagnetic layer 152 that operates as magnetization fixing layer may be fixed by using, for instance, the antiferromagnetic layer 151.

The underlayer 150 is typically used to facilitate the operation of forming the ferromagnetic layers and the antiferromagnetic layer and protect them. It is provided whenever necessary. The protection layer 155 is typically used to protect the ferromagnetic layers and the antiferromagnetic layer. Like the underlayer 150, it is provided whenever necessary. For instance, the protection layer 155 may be formed by utilizing the hard mask layer that is used when patterning the antiferromagnetic layer 151, the ferromagnetic layer 152, the tunnel barrier layer 153, the ferromagnetic layer 154 and the protection layer 155.

The above description on the underlayer 150 and the protection layer 155 applies also to the second through fourth examples, which will be described hereinafter.

Examples of materials that can be used for the ferromagnetic layers 152, 154 include the following.
Fe, Co, Ni and alloys of any of them,
magnetite showing a large spinning polarizability,
oxides such as CrO₂ and RXMnO_{3-y} (R: rare earth element, X: Ca, Ba or Sr),
Heusler alloys such as NiMnSb and PtMnSb

Materials that can be used for the ferromagnetic layers 152, 154 including those listed above may contain one or more than one non-magnetic elements so long as they do not make the layers lose ferromagnetism.

Examples of non-magnetic elements include the following.
Ag, Cu, Au, Al, Mg, Si, Bi, Ta, B, C, O, N,
Pd, Pt, Zr, Ir, W, Mo, Nb

The thickness of the ferromagnetic layers 152, 154 may be such that the ferromagnetic layers 152, 154 do not become super-paramagnetic. Specifically, the ferromagnetic layers 152, 154 may have a thickness not less than 0.4 nm. While there is no limit to the thickness of the ferromagnetic layers 152, 154, the thickness is preferably not more than 100 nm from the viewpoint of preparing TMR elements.

Examples of materials that can be used for the antiferromagnetic layer 151 include the following.
Fe-Mn, Pt-Mn, Pt-Cr-Mn, Ni-Mn, Ir-Mn, NiO, Fe₂O₃

Examples of materials that can be used for the tunnel barrier layer 153 include the following.
Al₂O₃, SiO₂, MgO, AlN, Bi₂O₃, MgF₂, CaF₂,
SrTiO₂, AlLaO₃

Materials that can be used for the tunnel barrier layer 153 including those listed above may contain at least oxygen, nitrogen or fluorine to such an extent that it does not make the obtained layer lose the insulating effect. On the other hand, they may be devoid of at least oxygen, nitrogen or fluorine so long as the obtained layer does not lose the insulating effect.

While the tunnel barrier layer 153 preferably has a small thickness, there are no limitations to the thickness, although the thickness of the tunnel barrier layer 153 may preferably have a thickness not more than 10 nm from the viewpoint of preparing TMR elements.

### [2nd Example]

FIG. 10B is a schematic cross sectional view showing a magneto-resistive effect element according to a second example.

The TMR element illustrated as a second example is referred to as of the double junction type.

As shown in FIG. 10B, an antiferromagnetic layer 151-1, a ferromagnetic layer 152-1, a tunnel barrier layer 153-1, a ferromagnetic layer 154, a tunnel barrier layer 153-2, a ferromagnetic layer 152-2, an antiferromagnetic layer 151-2 and a protection layer 155 are sequentially formed on an underlayer 150.

In this example, the ferromagnetic layers 152-1, 152-2 operate as magnetization fixing layers, whereas the ferromagnetic layer 154 operates as magnetic recording layer. The antiferromagnetic layer 151-1 is a layer to be used for fixing the spinning direction of the ferromagnetic layer 152-1, while the antiferromagnetic layer 151-2 is a layer to be used for fixing the spinning direction of the ferromagnetic layer 152-2.

If compared with a TMR element (single junction type) shown in FIG. 10A, a double junction type TMR element as shown in FIG. 10B provides an advantage that it can increase the ratio of the resistance for the low resistance operation and the resistance for the high resistance operation, or so-called MR ratio (magneto-resistance ratio).

The materials described above for the first example may also be used for the antiferromagnetic layers 151-1, 151-2, the ferromagnetic layers 152-1, 152-2, 154 and the tunnel barrier layers 153-1, 153-2 of this example.

The description about the thickness of the ferromagnetic layers of the first example also applies to the thickness of the ferromagnetic layers 151-1, 151-2, 154 of this example.

The materials and the thickness described above for the first example may also be used for the tunnel barrier layers 153-1, 153-2 of this example..

### [3rd Example]

FIG. 10C is a schematic cross sectional view showing a magneto-resistive effect element according to a third example.

As shown in FIG. 10C, the TMR element of the third example is obtained by modifying the TMR element of the first example in such a way that the ferromagnetic layers 152, 154 have a stack structure of a ferromagnetic layer and a non-magnetic layer. An example of such a stack structure may be three-layered film of ferromagnetic layer/non-magnetic layer/ferromagnetic layer like the one used in this example. In this example, the ferromagnetic layer 152 is three-layered film of ferromagnetic layer 161/non-magnetic layer 162/ferromagnetic layer 163, whereas the ferromagnetic layer 154 is three-layered film of ferromagnetic layer 164/non-magnetic layer 165/ferromagnetic layer 166.

Examples of materials listed above for the ferromagnetic layers of the first example may also be used for the ferromagnetic layers 161, 163, 164, 166.

Examples of materials that can be used for the non-magnetic layers 162, 165 include the following.
Ru, Ir

Specific examples of three-layered film of ferromagnetic layer/non-magnetic layer/ferromagnetic layer are listed below.
Co/Ru/Co, Co/Ir/Co
Co-Fe/Ru/Co-Fe, Co-Fe/Ir/Co-Fe

When the ferromagnetic layer 152 that operates as magnetization fixing layer is made to have a stack structure, for example three-layered film of ferromagnetic layer 161/non-magnetic layer 162/ferromagnetic layer 163, it is desirable that an antiferromagnetic bond is produced between the ferromagnetic layer 161 and the ferromagnetic layer 163 with the non-magnetic layer 162 interposed between them. Additionally, an antiferromagnetic layer 151 is arranged so as to be held in contact with the three-layered film. Such a structure provides an advantage that the spinning direction of the ferromagnetic layer 152 operating as magnetization fixing layer, the ferromagnetic layer 163 in particular, can be fixed more firmly. Due to this advantage, the ferromagnetic layer 152, the ferromagnetic layer 163 in particular, is hardly influenced by a magnetic field produced by an electric current so that inadvertent reversion of the spinning direction of the ferromagnetic layer 152 operating as magnetization fixing layer can be reliably suppressed.

When the ferromagnetic layer 154 that operates as magnetic recording layer is made to have a stack structure, for example three-layered film of ferromagnetic layer 164/non-magnetic layer 165/ferromagnetic layer 166, it is desirable that an antiferromagnetic bond is produced between the ferromagnetic layer 164 and the ferromagnetic layer 166 with the non-magnetic layer 165 interposed between them. In this case, the magnetic flux is closed in the above described three-layered film so that it is possible to suppress any possible increase in the switching magnetic field attributable to magnetic poles. As a result, there is provided an advantage that it is possible to suppress any possible increase of power consumption caused by a magnetic field produced by an electric current attributable to a demagnetizing field.

The ferromagnetic layer 154 that operates as magnetic recording layer may alternatively be made to have a stack structure of a soft ferromagnetic layer and a ferromagnetic layer. A soft ferromagnetic layer as used herein refers to a layer whose spinning direction can be more easily reversed than the spinning direction of a ferromagnetic layer.

When the ferromagnetic layer 154 is made to have a stack structure of a soft ferromagnetic layer and a ferromagnetic layer, the soft ferromagnetic layer is arranged close to the wire for generating a magnetic field by means of an electric current, a bit line for instance.

The stack structure may be made to additionally include a non-magnetic layer. In the case of three-layered film of ferromagnetic layer 164/non-magnetic layer 165/ferromagnetic layer 166 as described above for this example, the ferromagnetic layer 166 may be replaced by a soft ferromagnetic layer.

While both the ferromagnetic layers 152 and 154 are made to have a stack structure in this example, only the ferromagnetic layer 152 or the ferromagnetic layer 154 may alternatively be made to have a stack structure.

### [4th Example]

FIG. 10D is a schematic cross sectional view showing a magneto-resistive effect element according to a fourth example.

As shown in FIG. 10D, the TMR element of the fourth example is obtained by modifying the TMR element of the second example in such a way that the ferromagnetic layers 152-1, 154, 152-2 have a stack structure as described above with reference to the third example.

In this example, the ferromagnetic layer 152-1 is three-layered film of ferromagnetic layer 161-1/non-magnetic layer 162-1/ferromagnetic layer 163-1 and the ferromagnetic layer 154 is three-layered film of ferromagnetic layer 164/non-magnetic layer 165/ferromagnetic layer 166, whereas the ferromagnetic layer 152-2 is three-layered film of ferromagnetic layer 161-2/non-magnetic layer 162-2/ferromagnetic layer 163-2.

Examples of materials listed above for the ferromagnetic layers of the first example may also be used for the ferromagnetic layers 161-1, 161-2, 163-1, 163-2, 164, 166 of this example.

Examples of materials listed above for the non-magnetic layers of the third examples may also be used for the non-magnetic layers 162-1, 162-2, 165 of this example.

While the ferromagnetic layers 152-1, 154, 152-2 of this example are made to have a stack structure in this example, at least only one of them may alternatively be made to have a stack structure.

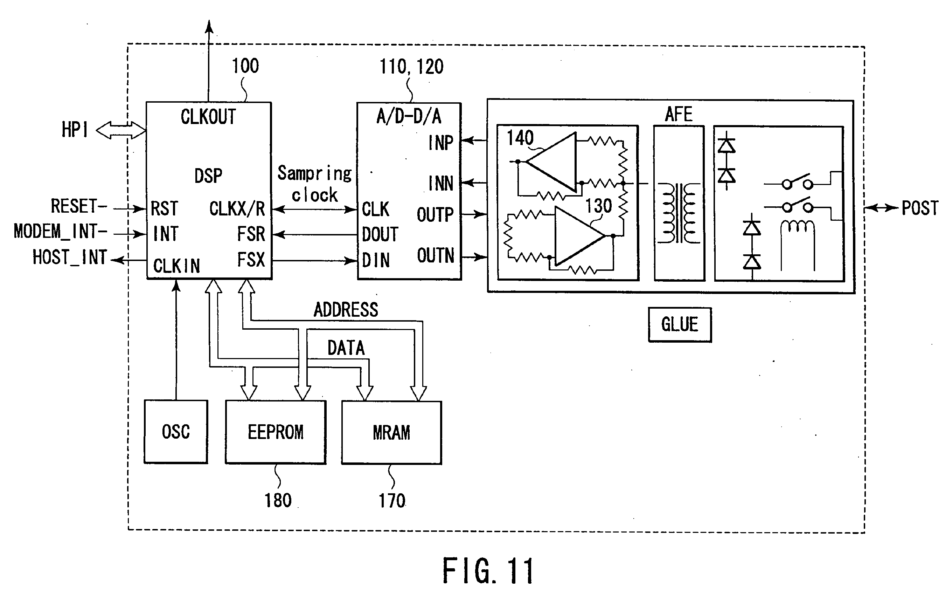

The magnetic random access memory (semiconductor memory device) according to the first to third embodiments of this invention can be applied to various devices. Some of the application examples are explained with reference to FIGS. 11 to 17.

### (Application Example 1)

FIG. 11 shows an extracted DSL data path portion of a modem for digital subscriber lines (DSL). The modem includes a programmable digital signal processor (DSP) 100, analog/digital (A/D) converter 110, digital/analog (D/A) converter 120, transmission driver 150 and receiver amplifier 160. In FIG. 11, a band pass filter is omitted and a magnetic random access memory 170 and EEPROM 180 of this embodiment are shown as various types of optional memories used to hold a line code program (a program which permits a modem to be selected and operated according to coded subscriber line information and transfer condition (line code; OAM, CAP, RSK, FM, AM, PAM, DWMT and the like) performed by use of the DSP) instead of the band pass filter.

In the present example, two types of memories of the magnetic random access memory 170 and EEPROM 180 are used as a memory to hole the line code program. However, the EEPROM 180 can be replaced by a magnetic random access memory. That is, instead of using two types of memories, only the magnetic random access memory can be used.

### (Application Example 2)

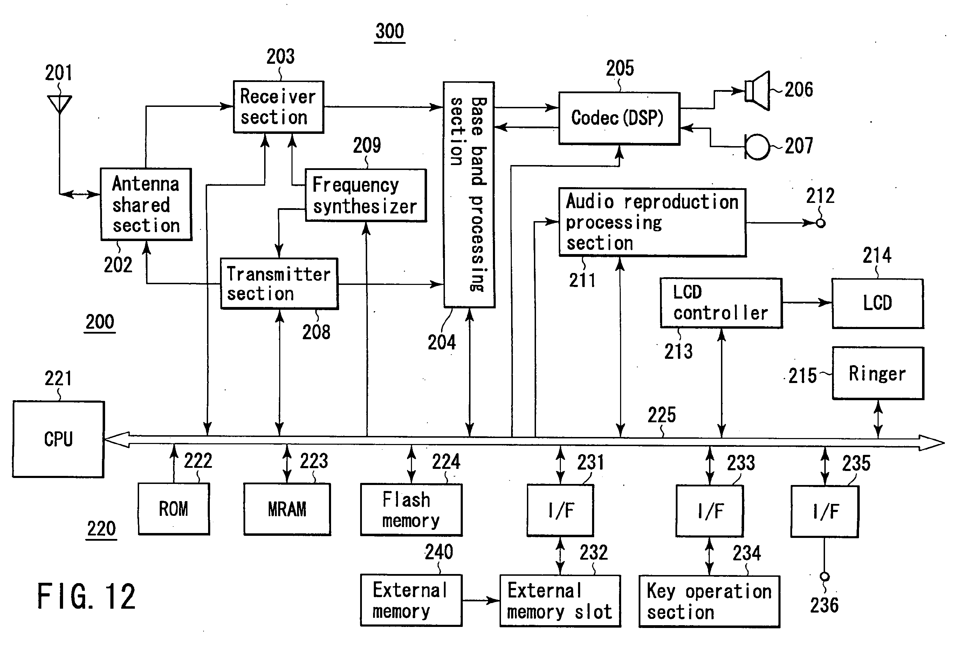

FIG. 12 shows a portable telephone terminal 300 as another application example. A communication section 200 which realizes the communication function includes a transmission/reception antenna 201, antenna shared section 202, receiver section 203, base band processing section 204, DSP 205 used as a voice codec, speaker (receiver) 206, microphone (transmitter) 207, transmitter section 208 and frequency synthesizer 209.

Further, the portable telephone terminal 300 includes a control section 220 which controls various sections of the portable telephone terminal. The control section 220 is a microcomputer to which a CPU 221, ROM 222, a magnetic random access memory (MRAM) 223 of this embodiment and flash memory 224 are connected via a CPU bus 225. A program executed by the CPU 221 and necessary data for display fonts are previously stored in the ROM 222. The MRAM 223 is mainly used as a working area. It is used to store data obtained in the course of calculations as required while the CPU 221 is executing the program or temporarily store data transferred between the control section 220 and the other sections. Further, when the power supply of the portable telephone terminal 300 is turned OFF, it is desired in some cases to store the set condition obtained immediately before turn-OFF of the power supply and set the same condition when the power supply is next turned ON. For this purpose, the flash memory 224 is used to store set parameters associated with the set condition. Thus, if the power supply of the portable telephone terminal is turned OFF, there is no possibility that the stored set parameters will be lost.

Further, the portable telephone terminal 300 includes an audio reproduction processing section 211, external output terminal 212, LCD controller 213, LCD (liquid crystal display) 214 and a ringer 215 which generates a call sound. The audio reproduction processing section 211 reproduces audio information input to the portable telephone terminal 300 (or audio information stored in an external memory 240 which will be described later). The reproduced audio information is transmitted to a head phone or mobile speaker via the external output terminal 212 and thus can be output to the exterior. Thus, by providing the audio reproduction processing section 211, audio information can be reproduced. For example, the LCD controller 213 receives display information from the CPU 221 via the CPU bus 225, converts the display information into LCD control information used to control the LCD 214 and drives the LCD 214 for display.

In addition, the portable telephone terminal 300 includes interface circuits (I/F) 231, 233, 235, external memory 240, external memory slot 232, key operation section 234 and external input/output terminal 236. A memory card such as the external memory 240 is inserted into the external memory slot 232. The external memory slot 232 is connected to the CPU bus 225 via the interface circuit (I/F) 231. Thus, by providing the slot 232 in the portable telephone terminal 300, it becomes possible to write information in the internal portion of the portable telephone terminal 300 into the external memory 240 and input information (for example, audio information) stored in the external memory 240 to the portable telephone terminal 300. The key operation section 234 is connected to the CPU bus 225 via the interface circuit (I/F) 233. Key input information input from the key operation section 234 is transmitted to the CPU 221, for example. The external input/output terminal 236 is connected to the CPU bus 225 via the interface circuit (I/F) 235. Thus, the terminal 236 functions as a terminal which inputs various information items from the exterior to the portable telephone terminal 300 or outputs information from the portable telephone terminal 300 to the exterior.

In this application example, the ROM 222, RAM 223 and flash memory 224 are used, but it is possible to replace the flash memory 224 by a magnetic random access memory and further replace the ROM 222 by a magnetic random access memory.

### (Application Example 3)

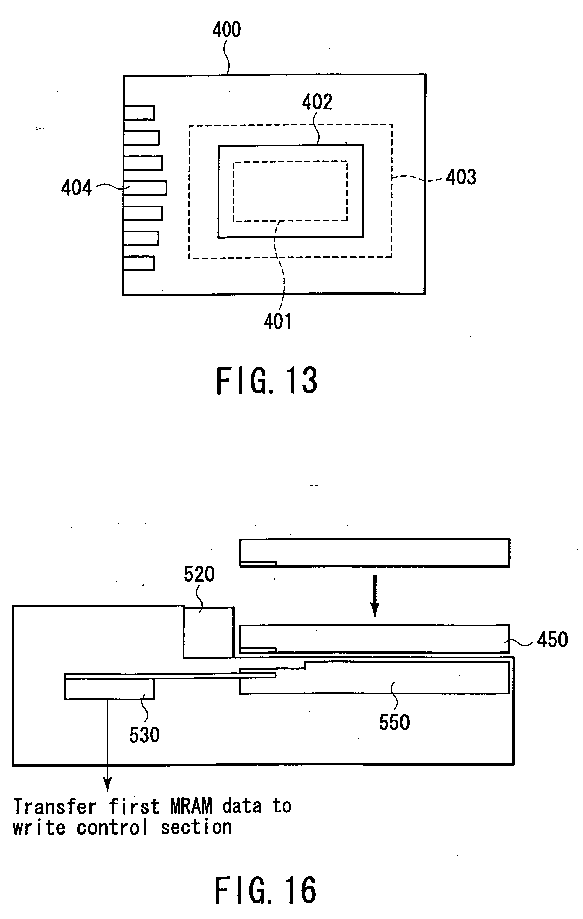

FIGS. 13 to 17 show examples in which a magnetic random access memory is applied to cards (MRAM cards) which receive media contents such as smart media or the like.

An MRAM chip 401 is contained in an MRAM card body 400. An opening portion 402 corresponding in position to the MRAM chip 401 is formed in the card body 400 so as to expose the MRAM chip 401. A shutter 403 is provided on the opening portion 402 so that the MRAM chip 401 can be protected by the shutter 403 when the MRAM card is carried. The shutter 403 is formed of a material such as ceramic which has an effect of shielding external magnetic fields. When data is transferred, the shutter 403 is released to expose the MRAM chip 401. An external terminal 404 is used to output contents data stored in the MRAM card to the exterior.

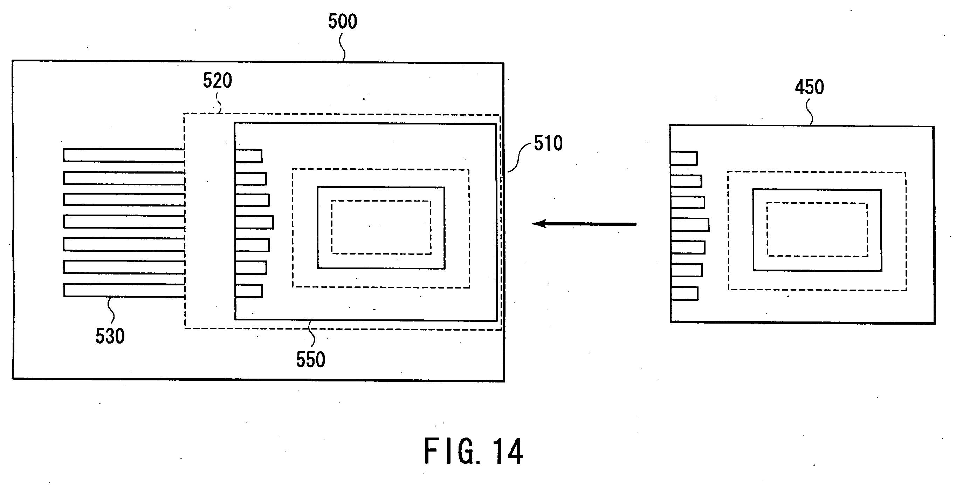

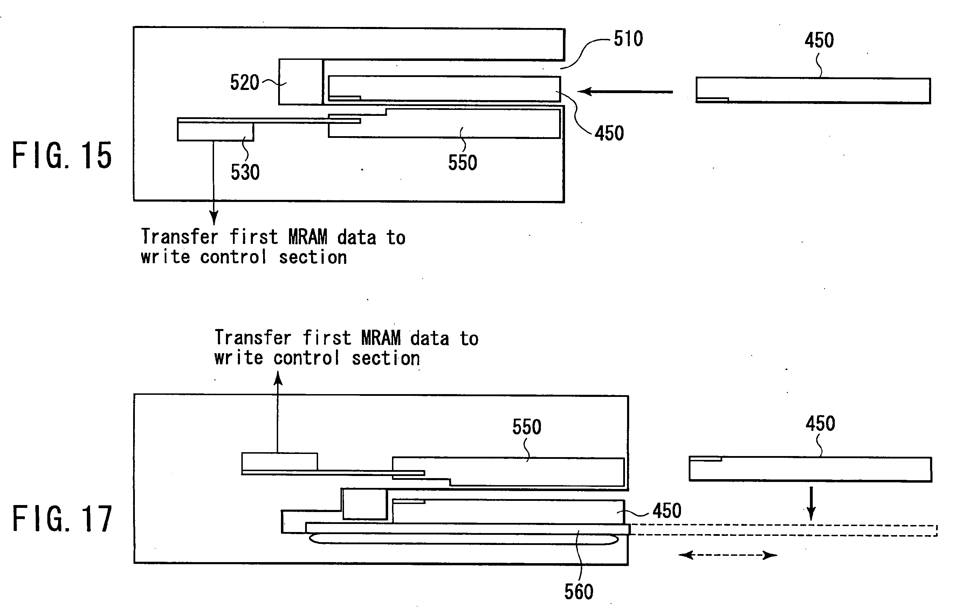

FIGS. 14 and 15 show a transfer device which transfers data to the MRAM card. FIG. 14 is a top plan view of a card insertion type transfer device and FIG. 15 is a cross-sectional view showing the transfer device. A second MRAM card 450 which an end user uses is inserted via an inserting portion 510 of a transfer device 500 as indicated by an arrow and pushed into the transfer device until it is stopped by a stopper 520. The stopper 520 also functions as a member which aligns the second MRAM card 450 with a first MRAM 550. When the second MRAM card 450 is placed in a preset position, a control signal is supplied from a first MRAM data rewriting control section to an external terminal 530. As a result, data stored in the first MRAM 550 is transferred to the second MRAM card 450.

FIG. 16 shows a fitting type transfer device. The transfer device is of a type in which the second MRAM card 450 is fitted into and mounted on the first MRAM 550 as indicated by an arrow with the stopper 520 used as a target. The data transfer method is the same as that of the card insertion type and the explanation thereof is omitted.

FIG. 17 shows a slide type transfer device. Like a CD-ROM driver or DVD driver, a transfer device 500 has a reception plate slide 560 and the reception plate slide 560 is moved in a direction as indicated by an arrow. When the reception plate slide 560 is moved to a position indicated by broken lines, the second MRAM card 450 is placed on the reception plate slide 560 and then inserted into the transfer device 500. The fact that the second MRAM 450 is inserted and the front end portion thereof abuts against the stopper 520 and the data transfer method are the same as those of the card insertion type and the explanation thereof is omitted.

While the present invention is described above by way of the first through third embodiments, the present invention is by no means limited to these embodiments, which may be modified or altered in various different ways without departing from the scope of the invention.

Additionally, while the first through third embodiments may be realized independently, any two of them or all the three may be combined appropriately for use.

Still additionally, each of the first through third embodiments includes various different phases of the invention. Therefore, any of such different phases of the invention may be extracted by appropriately combining a plurality of components of the invention as disclosed above by way of the embodiments.

Furthermore, while the above described first through third embodiments are magnetic random access memories, a semiconductor integrated circuit device containing any of such magnetic random access memories, for instance a processor or a system LSI, is also found within the scope of the present invention.

Thus, as described above by way of the first through third embodiments, according to the invention, there is provided a semiconductor integrated circuit device comprising memory cells including magneto-resistive elements and adapted to write data to a multiple of bits at the same time.

## Claims

1. A semiconductor integrated circuit device **characterized by** comprising:
a data line group (1) including a plurality of data lines (I/O 0 to I/O 3);
a first bit line group (2-0) including a plurality of bit lines (BL00 to BL30);
a first column gate circuit (CG0) that electrically connects the first bit line group (2-0) to the data line group (1) according to a first column selection signal (CSL0);
a second bit line group (2-1) including a plurality of bit lines (BL01 to BL31);
a second column gate circuit (CG1) that electrically connects the second bit line group (2-1) to the data line group (1) according to a second column selection signal (CSL1) different from the first column selection signal (CSL0);
a plurality of word lines (WWL0 to WWL7) intersecting the plurality of bit lines (BL00 to BL30 and BL01 to BL31) included in the first and second bit line groups (2-0 and 2-1); and
a plurality of memory cells (10) including magneto-resistive elements (12) and adapted to be electrically connected to a plurality of bit lines (BL00 to BL30 and BL01 to BL31) included in the first and second bit line groups (2-0 and 2-1) and selected by the plurality of word lines (WWL0 to WWL7), spinning directions of the magneto-resistive elements (12) being perpendicular to the plurality of bit lines (BL00 to BL30 and BL01 to BL31) included in the first and second bit line groups (2-0 and 2-1)as seen on a plan view.

2. A semiconductor integrated circuit device **characterized by** comprising:
a data line group (1) including a plurality of data lines (I/O 0 to I/O 3);
a first bit line group (2-0) including a plurality of bit lines(BL00 to BL30);
a first column gate circuit (CG0) that electrically connects the first bit line group (2-0) to the data line group (1) according to a first column selection signal (CSL0);
a second bit line group (2-1) including a plurality of bit lines (BL01 to BL31);
a second column gate circuit (CG1) that electrically connects the second bit line group (2-1) to the data line group (1) according to a second column selection signal (CSL1) different from the first column selection signal (CSL0);
a plurality of word lines (WWL0 to WWL7) intersecting the plurality of bit lines (BL00 to BL30 and BL01 to BL31) included in the first and second bit line groups (2-0 and 2-1); and
a plurality of memory cells (10) including magneto-resistive elements (12) and adapted to be electrically connected to a plurality of bit lines (BL00 to BL30 and BL01 to BL31) included in the first and second bit line groups (2-0 and 2-1) and selected by the plurality of word lines (WWL0 to WWL7), the magneto-resistive elements (12) being rectangular with short sides and long sides as seen on a plan view and the long sides intersecting the plurality of bit lines (BL00 to BL30 and BL01 to BL31) included in the first and second bit line groups (2-0 and 2-1) as seen in a plan view.

3. A semiconductor integrated circuit device **characterized by** comprising:
a data line group (1) including a plurality of data lines(I/O 0 to I/O 3);
a first bit line group (2-0) including a plurality of bit lines (BL00 to BL30);
a first column gate circuit (CG0) that electrically connects the first bit line group (2-0) to the data line group (1) according to a first column selection signal (CSL0)
a second bit line group (2-1) including a plurality of bit lines (BL01 to BL31);
a second column gate circuit (CG1) that electrically connects the second bit line group (2-1) to the data line group (1) according to a second column selection signal (CSL1) different from the first column selection signal (CSL0);
a plurality of word lines (WWL0 to WWL7) intersecting the plurality of bit lines (BL00 to BL30 and BL01 to BL31) included in the first and second bit line groups (2-0 and 2-1); and
a plurality of memory cells (10) including magneto-resistive elements (12) and adapted to be electrically connected to a plurality of bit lines (BL00 to BL30 and BL01 to BL31) included in the first and second bit line groups (2-0 and 2-1) and selected by the plurality of word lines (WWL0 to WWL7), the magneto-resistive elements (12) being parallelogramic with short sides and long sides as seen on a plan view and the long sides intersecting the plurality of bit lines (BL00 to BL30 and BL01 to BL31) included in the first and second bit line groups (2-0 and 2-1) as seen in a plan view.

4. The device according to any one of claims 1 to 3, **characterized in that** the pitch of arrangement of the first bit line group (2-0) and the second bit line group (2-1) is greater than the pitch of arrangement of the bit lines (BL00 to BL30 and BL01 to BL31) included in the first and second bit line groups (2-0 and 2-1).

5. The device according to any one of claims 1 to 3, **characterized in that** the pitch of arrangement of the magneto-resistive elements (12) is greater between the first and second bit line groups (2-0 and 2-1) than in the first and second bit line groups (2-0 and 2-1).

6. The device according to any one of claims 1 to 3, **characterized in that** the plurality of memory cells (10) include transistors (13) electrically connected to the respective magneto-resistive elements (12).

7. The device according to any one of claims 1 to 3, **characterized in that** the plurality of memory cells (10) include diodes electrically connected to the respective magneto-resistive elements (12).

8. The device according to any one of claims 1 to 3, **characterized in that** the magneto-resistive elements (12) are tunnel magneto-resistive effect elements of the double junction type having a first magnetization fixing layer (152-1), a first tunnel barrier layer (153-1), a magnetic recording layer (154), a second tunnel barrier layer (153-2) and a second magnetization fixing layer (152-2).

9. The device according to any one of claims 1 to 3, **characterized in that** the magneto-resistive elements (12) are tunnel magneto-resistive effect elements having a magnetization fixing layer (152), a tunnel barrier layer (153) and a magnetic recording layer (154) and at least the magnetization fixing layer (152) includes a stack structure of a ferromagnetic layer (161) and a non-magnetic layer (162).

10. The device according to any one of claims 1 to 3, **characterized in that** the magneto-resistive elements (12) are tunnel magneto-resistive effect elements of the double junction type having a first magnetization fixing layer (152-1), a first tunnel barrier layer (153-1), a magnetic recording layer (154), a second tunnel barrier layer (153-2) and a second magnetization fixing layer (152-2) and at least either of the first and second magnetization fixing layers (152-1 and 152-2) and the magnetic recording layer (154) include a stack structure of a ferromagnetic layer (161 or 164) and a non-magnetic layer(162 or 165).
